# EUROPÄISCHE PATENTSCHRIFT

(11) **EP 2 655 686 B1**
(45) Veröffentlichungstag und Bekanntmachung des Hinweises auf die Patenterteilung: **22.11.2017**
(21) Anmeldenummer: 11802863.8
(22) Anmeldetag: 16.12.2011
(51) Int. Cl.: C23C 14/24, C23C 14/56, B05B 1/00, H01L 31/0392

(54) **VERDAMPFERQUELLE UND BESCHICHTUNGSVERFAHREN**
VAPORIZATION SOURCE AND COATING METHOD
SOURCE DE VAPORISATEUR ET PROCÉDÉ DE REVÊTEMENT

(30) Priorität: 21.12.2010 DE 102010055285
(43) Veröffentlichungstag der Anmeldung: 30.10.2013
(73) Patentinhaber: OC3 AG, 04442 Zwenkau (DE)
(72) Erfinder: ULMER, Frank, verstorben (DE); GÖBERT, Christof, 06847 Dessau-Rosslau (DE); ZACHMANN, Hendrik, 04107 Leipzig (DE); RÖSSLER, Jens, 04451 Borsdorf (DE); SCHULER, Heiko, 75397 Simmozheim (DE); HUBER, Frank, 72074 Tübingen (DE); LEIFELD, Oliver, 70569 Stuttgart (DE)
(74) Vertreter: Hecht, Jan-David
(86) Internationale Anmeldenummer: PCT/EP2011/006383
(87) Internationale Veröffentlichungsnummer: WO 2012/084165

(56) Entgegenhaltungen:
- EP-A1- 1 967 604
- EP-A1- 1 970 474
- EP-A2- 1 505 167
- EP-A2- 2 213 762
- NL-C2- 2 001 289

## Beschreibung

Die Erfindung betrifft eine Linearverdampferquelle nach dem Oberbegriff von Anspruch 1 und ein Beschichtungsverfahren nach dem Oberbegriff von Anspruch 11.

Abscheidetechniken zur Herstellung von dünnen Schichten unter Vakuumbedingungen sind allgemein bekannt. Für den industriellen Einsatz von Molekularstrahlepitaxie (MBE)- und anderen Aufdampfverfahren steigen die Anforderungen stetig, insbesondere bei einer flexiblen Substratführung, mit wachsender Substratbreite mit Blick auf eine homogene Schichtabscheidung, einer möglichst hohen Abscheiderate und deren Betriebsumgebung.

Bspw. drängen in der Photovoltaik immer mehr Anbieter von Dünnschichtsolarzellen auf den Markt. Dünnschichtsolarzellen, die insbesondere auf einer Chalkopyrit-Absorberschicht basieren, werden überwiegend auf starren Trägersubstraten wie Glas hergestellt, haben aber den Vorteil, dass sie auch auf leichten, flexiblen Trägersubstraten, beispielsweise in einem Rolle-zu-Rolle (R2R)-Prozess hergestellt werden können. Als flexible Substrate kommen z.B. Stahl-, Titan-, Aluminium-, Kupfer-, Polyimid (P1)-Folien infrage. Das Substrat wird mit einer metallischen Elektrode, etwa einem dünnen Molybdänfilm beschichtet. Anschließend wird das Chalkopyrit als Absorberschicht, zumeist in einem Verdampfungsprozess im Vakuum, aufgetragen. Als Chalkopyrite, nachfolgend als CIS bezeichnet, werden vor allem CuInSe₂, Cu(In,Ga)Se₂, Cu(In,Ga)(Se,S)₂ verwendet. Als besonders vorteilhaft hat sich herausgestellt, wenn die Elemente in einer Schwefel, Tellur- und/oder Selenatmophäre verdampft werden. Anschließend wird eine Halbleiterschicht aus CdS oder dergleichen sowie eine zweite Elektrodenschicht (auf der Vorderseite), die aus einer dünnen transparenten leitfähigen Schicht (TCO- transparent conductive oxide), etwa ITO (Indium/Zinn-Oxid) oder ZnO besteht, aufgebracht. Zudem lässt sich der Wirkungsgrad von CIS-Solarzellen durch gezielte Zufuhr von Alkalinen, vorzugsweise Lithium, Kalium und Natrium und/oder deren Verbindungen mit Sauerstoff, Schwefel oder mit Halogeniden verbessern, was unter anderem durch Verdampfen realisiert werden kann.

Um die Kosten des Herstellungsprozesses, vor allem des CIS-Absorbers weiter zu minimieren, wird in den nächsten Jahren die Substratbreite weiter steigen und die Abscheideraten werden erhöht werden. Die Entwicklung weg von punktförmigen hin zu linienförmigen Verdampferquelle ist daher unausweichlich, da sich damit eine effizientere Hochrateabscheidung hinsichtlich der Materialausbeute umsetzen lässt.

Eine linienförmige Verdampferquelle, im weiteren Verlauf als Linearverdampferquelle bezeichnet, ist eine Aneinanderreihung einer Vielzahl, d.h. von mindestens zwei punktförmigen Verdampferquellen, im weiteren Verlauf als Punktverdampfer bezeichnet, die gemeinsam einen Verdampfungsmaterialbehälter besitzen oder eine Verdampferapparatur deren Dampfaustrittsöffnung in Längsrichtung der Linearverdampferquelle schlitzförmig ausgebildet ist, d.h. dass die Längserstreckung der Dampfaustrittsöffnung wesentlich größer gegenüber der Quererstreckung ist.

Eine der größten Herausforderungen bei der Entwicklung von Linearverdampferquellen ist die Gewährleistung der bestmöglichen Querhomogenität der auf dem Substrat aufgedampften Schichten. Die Querhomogenität des Substrats ist als Homogenität der aufgedampften Schicht orthogonal zur Transportrichtung definiert. Eine Möglichkeit die Querhomogenität zu optimieren, ist die Anpassung der Molekülflussdichte entlang der Längsrichtung der Linearverdampferquelle, die mit ihrer Längsrichtung parallel zur Querrichtung des Substrates angeordnet ist.

Bei diesem Ansatz wird die Fläche von mehreren in Längsrichtung der Linearverdampferquelle angeordneten Dampfaustrittsöffnungen von innen nach außen vergrößert und/oder der Abstand mehrerer in Längsrichtung der linienförmigen Verdampferquelle angeordneten Dampfaustrittsöffnungen von innen nach außen verkleinert, woraus sich ein von innen nach außen ansteigender Gradient von Molekülflussdichten der aus den Dampfaustrittsöffnungen entstehenden Molekülstrahlen des Verdampfungsmaterials ergibt, welche sich an der Substratoberfläche zu einem homogenen Film überlagern. Eine weitere Möglichkeit die Querhomogenität zu beeinflussen ist die Modulation der Molekularstrahlform.

Im Folgenden wird zwischen Dampfaustrittsöffnung und Dampfdurchsatzöffnungen unterschieden, wobei Dampfaustrittsöffnungen solche sind, an der der Dampf die Verdampferquelle verlässt. Bei Öffnungen, wie zum Beispiel solchen von Drosselblenden, verlässt das Material nicht die Verdampferquelle, weshalb solche Öffnungen als Dampfdurchsatzöffnung bezeichnet werden.

In EP 0 402 842 B1 wird eine Verdampferapparatur beschrieben, bei der aus mindestens einem Röhrchen eine Substanz verdampft wird, um den Dampf als angeregtes oder ionisiertes Medium in einer Dampfionen-Laservorrichtung zu verwenden, wobei der Durchmesser der Dampfaustrittsöffnungen nahe der axial entgegengesetzten Enden des Röhrchens größer ist als in der Mitte oder die Anzahl von Dampfaustrittsöffnungen nach Außen hin zunimmt.

In DE 44 22 697 C1 wird eine Linearverdampferquelle gezeigt, die aus einem nach oben offenen Verdampfungsgutbehälter mit einer Material aufnehmenden Vertiefung und einem dem Verdampfungsgutbehälter umgebenden beheizbaren Reflektorrohrkörper besteht, dessen linienförmiges Austrittprofil aus einer Mehrzahl von hintereinander liegenden Einzelöffnungen besteht und deren Austrittsquerschnitt zu den Endbereichen des Reflektorrohres zunimmt und/oder deren Abstand zu den Endbereichen des Reflektorrohres hin abnimmt. Weiterhin ist ein Hitzeschild um das Reflektorrohr angeordnet, das im Bereich des einen Dampfaustrittsschlitzes so ausgebildet ist, dass keine Beeinflussung des Verdampfungsstromes erfolgt.

Die EP 1 927 674 A2 beschreibt eine Linearverdampferquelle bestehend aus einer Verdampfungskammer und einer darüber liegenden Düseneinheit (Cabinet Part), die über eine Düsen- bzw. Drosselblende (Control Plate) miteinander verbunden sind, wobei die Düseneinheit mehrere Düsen aufweist. Die Düsenblende besteht aus Dampfdurchsatzöffnungen, deren Fläche von Blendenmitte zum Blendenrand hin kontinuierlich größer wird und/oder der Abstand der Dampfdurchsatzöffnungen wird von der Blendenmitte zum Blendenrand hin kleiner. Die Molekularstrahlen der Dampfdurchsatzöffnungen werden durch Partitionsplatten in der Düseneinheit voneinander getrennt.

Die WO 2008/004792 A1 beschreibt eine Linearverdampferquelle bestehend aus einem Tiegel und eine aus mehreren Dampfaustrittsöffnungen bestehenden Düseneinheit. Die Dampfaustrittsöffnungen sind als röhrenförmige Düsen, deren Längsachsen in einem Winkel zur Höhenachse des Tiegels stehen, in die Düseneinheit eingebracht. Die röhrenförmigen Düsen sind entlang der Längsausprägung des Tiegels spiegelsymmetrisch bezüglich der Höhenebenen (längs- und querausgeprägte Höhenebene) des Tiegels in zwei oder vier angeordnete Gruppen eingeteilt, wobei die Düsen innerhalb einer Gruppe unterschiedlich geneigt sein können. Weiterhin kann die Fläche der Austrittsöffnungen der Düsen über die Ausbildung eines Plateaus der Düseneinheit variiert werden.

Diese beschriebenen Konzepte sind zumeist sehr kompliziert aufgebaut und/oder können dennoch nicht die notwendige Homogenität bereitstellen.

Die EP 1 505 167 A2 zeigt eine Verdampferquelle, bei der ein zylindrischer Verdampfungsmaterialbehälter von einer Behälterabdeckung verschlossen ist, die eine konisch sich verjüngende Öffnung aufweist.

Die EP 2 213 762 A2 zeigt eine Beschichtungskammer mit einem Verdampfer für Ingots, wobei die Dampfaustrittsöffnung konisch sich verjüngend ausgebildet ist. Dabei können auch mehrere Verdampfer in einer Kammer angeordnet sein.

Die EP 1 967 604 A1 zeigt eine sehr spezielle Form eines Verdampfers, bei dem ein Material als Draht eingebracht und entlang eines gewundenen Pfades verdampft wird. Der Verdampfer ist eine Punktverdampferquelle.

Aufgabe der Erfindung ist es, eine Linearverdampferquelle bereitzustellen, mit der die bisherigen Nachteile der bisher bekannten Verdampferquellen überwunden werden. Die erfindungsgemäße Linearverdampferquelle soll insbesondere unter Vakuumbedingungen in einer Schwefel-, Tellur- und/oder Selenatmosphäre eine möglichst hohe und stabile Masseflussrate mit verbesserter Schichtdickenhomogenität erzeugen. Vorteilhaft sollte die Molekularstromrichtung der Verdampferquelle gegenüber der über der Verdampferquelle befindlichen Substratführung- bzw. Halterung einstellbar sein. Außerdem ist auch ein verbessertes Verfahren mit bevorzugt kontinuierlicher Führung flexibler Substrate zur Herstellung von Vakuumaufdampfschichten, vorzugsweise Chalkopyritschichten, insbesondere CIS, von Interesse. Vorzugsweise soll die Linearverdampferquelle weiterhin flexibel der Substratbreite angepasst, d.h. aufskaliert werden können.

Diese Aufgabe wird durch die Linearverdampferquelle nach Anspruch 1 und das Beschichtungsverfahren nach Anspruch11 gelöst. Vorteilhafte Weiterbildungen sind in den abhängigen Ansprüchen angegeben.

Die erfindungsgemäße Linearverdampferquelle, insbesondere für Vakuumbeschichtungsanlagen, weist zumindest einen Verdampfungsmaterialbehälter mit einer Vertiefung zur Aufnahme des Verdampfungsmaterials, insbesondere Kupfer, Indium, Gallium aber auch Gold, Aluminium, Silber, sowie Natrium, Kalium und Lithium sowie deren Verbindungen mit Sauerstoff, Schwefel oder Halogenoiden und zumindest eine Heizquelle auf, wobei der Verdampfungsmaterialbehälter eine Behältersachse aufweist, und besitzt außerdem zumindest zwei in Längsrichtung der Linearverdampferquelle beabstandet angeordnete Düsen, wobei die Düsen jeweils mindestens eine Dampfaustrittsöffnung aufweisen, und zeichnet sich dadurch aus, dass zumindest eine Dampfaustrittsöffnung zumindest zwei Wandabschnitte, die sich bevorzugt im Wesentlichen senkrecht zur Längserstreckung erstrecken, aufweist, die nicht parallel zueinander orientiert und/oder orientierbar sind. Durch diese erfindungsgemäße Lösung lässt sich eine besonders wirksame Strahlformung bewirken, mit der sich eine optimale Schichthomogenität einstellen lässt.

Dabei können auch eine Düse, die sich in Längsrichtung der Linearverdampferquelle erstreckt, und zumindest zwei in Längsrichtung der Linearverdampferquelle beabstandete Düsen miteinander kombiniert werden, also beispielsweise eine Düse, die sich in Längsrichtung der Linearverdampferquelle erstreckt, beispielsweise einen rechteckigen Querschnitt aufweist, mit einer beabstandet angeordneten Düse, die keine besondere Längserstreckung aufweist, beispielsweise einen quadratischen oder runden Querschnitt aufweist. In diesem Fall ist also die rechteckige Düse gleichzeitig eine der beabstandet angeordneten Düsen.

Vorteilhaft kann vorgesehen sein, dass die Dampfaustrittsöffnung in Bezug auf die beiden Wandabschnitte bevorzugt konisch, insbesondere asymmetrisch konisch erweitert ausgebildet ist, wodurch sich das Strahlprofil noch günstiger beeinflussen lässt. Vorzugsweise handelt es sich um eine konisch erweiterte Ausbildung in Bezug auf die Dampfstrahlrichtung.

Besonders vorteilhaft ist es, wenn die Dampfaustrittsöffnung eine Längsachse aufweist, die zur Behälterachse verkippt angeordnet und/oder anordenbar ist, wobei die Verkippung vorzugsweise 1° bis 90°, bevorzugt 10° bis 60°, besonders bevorzugt 10° bis 45°, insbesondere 20° bis 30° beträgt. Dann lässt sich bei starren Flächensubstraten eine gleichzeitige Bedampfung eines bestimmten Substratbereichs von zwei oder mehr Linearverdampfern mit unterschiedlichem Verdampfungsmaterial besonders gut sicherstellen. Die Verkippung in dem beschriebenen Bereich eignet sich aber auch sehr gut für die Beschichtung von flexiblen Bandsubstraten auf einer gebogenen Substratführung. Sowohl bei starren als auch flexiblen Substraten kann sowohl eine In-line als auch eine Batch-Prozessierung vorgenommen werden.

"Behälterachse" meint in diesem Zusammenhang die Erstreckung zwischen Behälterboden und Behälterdeckel, in dem sich die Dampfaustrittsöffnung befindet, wobei diese Achse eine geometrische Achse in Bezug auf den Behälterkörper ist. Die Verkippung kann statisch vorhanden sein oder sich gezielt einstellen lassen, beispielsweise kontinuierlich oder diskret.

"Längsachse" der Düsenöffnung meint in diesem Zusammenhang die geometrische Achse der Düsenöffnung, wodurch auch die Vorzugsrichtung des austretenden Dampfes bestimmt wird.

Vorzugsweise kann vorgesehen sein, dass die Düsenöffnungen der Düsen des Verdampfers unterschiedlich zur Behälterachse ausgerichtete Längsachsen aufweisen.

Besonders vorteilhaft sind die Düsen in zumindest einem Düsenelement, bevorzugt einer Düsenplatte, angeordnet. Dann ist der Verdampfer besonders einfach aufgebaut. Insbesondere kann dann vorgesehen werden, dass das Düsenelement lösbar mit dem Verdampfungsmaterialbehälter verbunden ist. "Verbunden" heißt in diesem Zusammenhang sowohl direkt als auch indirekt, also unter Zwischenschalten weiterer Elemente verbunden. Dann kann der Verdampfer schnell an unterschiedliche Anforderungen angepasst werden, weil die Düsenelemente leicht ausgetauscht werden können. So kann die Strahlformung bei fest angeordneten Längsachsen der Dampfaustrittsöffnungen durch Drehen des Düsenelements einfach verändert werden. Die lösbare Verbindung kann beispielsweise über eine clipsartige Befestigung oder dgl. realisiert werden.

Besonders zweckmäßig ist zwischen Düse und Vertiefung ein Drosselelement angeordnet, das zumindest eine Drosselöffnung aufweist, die in Sichtrichtung zwischen Düse und Vertiefung angeordnet ist. "Sichtrichtung" meint in diesem Zusammenhang diejenige Richtung, die durch geometrische Strahlen zwischen jedem Punkt der Vertiefung und der Düse festgelegt ist. Es ist also diejenige Richtung gemeint, die durch Blicken durch die Düse in die Vertiefung festgelegt ist. Dieses Drosselelement bewirkt eine gezielte Einstellung der Materialdampfmenge für jede Düse. Dabei kann vorgesehen sein, dass jeder Düse eine einzige Drosselöffnung zugeordnet ist. Alternativ ist es aber auch möglich, jeder Düse ein oder mehrere Drosselöffnung zuzuordnen, die bevorzugt einen gleichen Querschnitt aufweisen.

Dabei kann bevorzugt die Gesamtquerschnittsfläche der Drosselöffnungen der jeweiligen Düse bei in Bezug auf die Längserstreckung zumindest einer weiter außen gelegenen Düse gleich oder größer sein als bei zumindest einer weiter innen liegenden Düse. Bevorzugt handelt es sich nur um die ganz außen liegenden Drosselöffnungen, die einen anderen Querschnitt aufweisen. Besonders durch eine außen vergrößerte Drosselquerschnittsfläche kann die Schichthomogenität positiv beeinflusst werden, weil dadurch Materialmengenverluste aufgrund weiter außen fehlender benachbarter Düsen kompensiert werden.

Außerdem ist es sehr vorteilhaft wenn in Sichtrichtung zwischen Vertiefung und Drosselöffnung und/oder in Sichtrichtung zwischen Drosselöffnung und Düse ein Blendenelement als Spritzschutz angeordnet ist, das insbesondere die Gesamtquerschnittsfläche der Drosselöffnungen in Sichtrichtung verdeckt. Durch dieses Blendenelement wird wirksam das Austreten von Verdampfungsmaterial in Form von Spritzern verhindert. Für diese Ausbildung wird auch selbständiger Schutz beansprucht, d.h. eine Verdampferquelle mit einem solchen Blendenelement soll auch ohne das Merkmal der besonderen Gestaltung der Düsenöffnung und deren besonderer Ausrichtung in Bezug auf die Behälterachse geschützt sein.

Zudem kann die Düse vorteilhaft mindestens einen Hitzereflektor aufweisen, der bevorzugt mindestens ein Blech aus einem temperaturbeständigen Material, beispielsweise einem Material aus der Gruppe umfassend Metalle der vierten bis zehnten Nebengruppe des Periodensystems der Elemente und/oder deren Legierungen, vorzugsweise Wolfram, Titan, Molybdän und Tantal - also bevorzugt hoch schmelzenden Metallen über 1200°C-, aufweist und zweckmäßig neben bzw. um die Dampfaustrittsöffnung herum angeordnet ist. Dieser Hitzreflektor dient dazu, den Temperaturgradienten zwischen Verdampfungsmaterialbehälter und Düsenoberfläche zu minimieren.

Zudem ist der Verdampfungsmaterialbehälter modular, d.h. in mehrere kleinere Verdampfungsmaterialbehälter, aufteilbar. Das Verhältnis der Längs- zur Quererstreckung L_{Längs}/L_{Quer} eines Verdampfungsmaterialbehältermoduls soll mindestens 5 und maxial 30, vorzugsweise 15 ≤ L_{Längs}/L_{Quer} ≤ 25, insbesondere 19 ≤ L_{Längs}// L_{Quer} ≤ 22 betragen. Bei einer Linearverdampferquellenlänge von bis zu 10 m wird der Verdampfungsmaterialbehälter in zwei, vorteilhaft 3 bis 40, bevorzugt 3 bis 20, insbesondere 5 bis 10 kleinere Verdampfungsmaterialbehälter aufgeteilt. Die einzelnen Verdampfungsmaterialbehälter sind so konstruiert, dass sich das Dampfdruckgleichgewicht aus der Verdampfung des Verdampfungsmaterials aus allen Verdampfungsmaterialbehältern gemeinsam ausbildet.

In diesem Zusammenhang oder alternativ ist es besonders bevorzugt, wenn die und ggf. weitere Düsen in einer Düsenplatte als Aperturblock angeordnet sind. Besonders zweckmäßig ist diese Düsenplatte massiv, bevorzugt aus Graphit bestehend ausgebildet.

Es kann auch vorgesehen sein, dass das Düsenelement oder die Düsenplatte modular mit mehreren Düsenelement- bzw. Düsenplattensegmenten ausgebildet ist. Dies ist für Linearverdampferquellen großer Längserstreckung vorteilhaft.

Die Düsenplatte dient der partiellen Regulierung des Dampfstroms im Fluss wie auch im Profil, wozu die Öffnungsquerschnitte der Dampfaustrittsöffnungen untereinander verschieden gestaltet und auch unterschiedlich beabstandet in der Düsenplatte angeordnet sein können, so dass die Düsenplatte eine für die jeweils gewünschte Prozessgeometrie angepasste Dampfaustrittsöffnungsanordnung aufweist. Abhängig von der Anzahl der Verdampfungsmaterialbehälter je Linearverdampferquelle kann eine gleiche Anzahl Düsenplatten vorgesehen werden. Für das gewünschte Beschichtungsprofil ist dann die Reihenfolge und Orientierung der einzelnen Düsenplatten wichtig. Alternativ kann auch eine Düsenplatte für zwei oder mehrere Verdampfungsmaterialbehälter vorgesehen werden kann.

Für diese Ausgestaltung der Düse und der Düsenplatte wird auch für sich selbständiger Schutz beansprucht, dass heißt, dass in diesem Zusammenhang keine besondere Anordnung der Wandabschnitte vorgesehen werden muss.

Außerdem wird für die Düsenplatte selbst in ihren unterschiedlichen Ausgestaltungen unabhängiger Schutz beansprucht. Dabei sind die mit der Düsenplatte und den Düsen verbundenen erfindungsgemäßen Merkmale beliebig kombinierbar und es ist nicht zwingend erforderlich, dass die Düsenplatte zumindest eine Dampfaustrittsöffnung mit zumindest zwei Wandabschnitten aufweist, die nicht parallel zueinander orientiert und/oder orientierbar sind.

Weiterhin wird selbständiger Schutz beansprucht für die erfindungsgemäße Verdampferkammer mit zumindest einer Verdampferquelle und zumindest einer Substrathalterung und/oder Substratführung für Flächensubstrate, flexible Bandsubstrate oder dgl., die sich dadurch auszeichnet, dass zumindest eine Verdampferquelle die erfindungsgemäße Linearverdampferquelle ist.

Bevorzugt ist dabei als Substratführung und/oder Substrathalterung ein eben verlaufender Abschnitt vorgesehen, in dem das Substrat bedampft wird, wobei als Substrat sowohl herkömmliche starre Substrate, wie Glas, als auch flexible Substrate verwendet werden können. Als Substratführung kann aber auch eine einen gebogenen Abschnitt aufweisende Bandsubstratführung verwendet und die Linearverdampferquelle so angeordnet werden, dass das Substratmaterial in diesem gebogenem Abschnitt aufgedampft wird. Bei Verwendung einer Substratführung geht man von einer Bewegung des Substrates aus, hierbei handelt es sich um eine dynamische Substratbeschichtung, wie sie bei "in line"-Prozessführungen vorgenommen wird. Bei der Verwendung einer Substrathalterung ist wird das Substrat während der Beschichtung gegenüber den Linearverdampferquellen nicht bewegt, hierbei handelt es sich um eine statische Beschichtung wie in "Batch"-Prozessen üblich.

Vorteilhaft bei einer ebenen Substratführung ist eine optimale, von der Verdampferposition unabhängige Ausnutzung der Beschichtungszone, während bei einer gebogenen Substratführung nur ein bestimmter von der Verdampferposition abhängiger Bereich beschichtet werden kann. Der Vorteil einer gebogenen gegenüber einer ebenen Bandsubstratführung besteht darin, dass ein wesentlich einfacheres Bandsubstrathandling erreicht wird.

Besonders vorteilhaft ist die Behälterachse der Linearverdampferquelle gegenüber der Gravitationsrichtung um 0° bis 40°, bevorzugt 10° bis 25°, insbesondere 15° angeordnet und/oder anordenbar. Dann lässt sich die Linearverdampferquelle vor allem auch bei Einsatz mehrerer Verdampferquellen besonders platzsparend in der Verdampferkammer unterbringen.

Wenn zumindest zwei Linearverdampferquellen vorgesehen sind, ist es zweckmäßig, wenn zumindest die zwei Linearverdampferquellen in Bezug auf ihre Behälterachsen zueinander schräg gestellt und/oder stellbar sind. Alternativ kann auch vorgesehen sein, dass zumindest zwei Linearverdampferquellen die gleiche Neigung gegenüber der Gravitationsachse aufweisen.

Außerdem ist es sehr günstig, wenn zumindest zwei Linearverdampferquellen vorgesehen sind, deren jeweilige Längsachsen der Dampfaustrittsöffnung zur jeweiligen Behälterachse unterschiedlich angeordnet sind. Vor allem, wenn die Behälterachsen senkrecht zur Gravitationsachse ausgerichtet sind, kann so bei definierter Strahlformung eine gleich bleibende Verdampferleistung sichergestellt werden, weil die Oberfläche des Verdampfungsmaterials in der Vertiefung bis zum vollständigen Verbrauch des Materials konstant gehalten ist. So gesehen ist auch eine Anordnung der Behälterachsen parallel zur Gravitationsachse sinnvoll.

Als besonders günstig hat sich erwiesen, wenn die beschriebene Linearverdampferquelle in der beschriebenen Verdampferkammer einen Abstand von 0,05 m bis 2,00 m, bevorzugt 0,1 m bis 1 m, insbesondere 0,3 m bis 0,7 m, zum Substrat hat, unabhängig davon ob die Beschichtungszone eben oder gebogen ausgebildet ist. Als Verdampfer-Substratabstand wird die kürzeste geradlinige Entfernung zwischen Substrat und Dampfaustrittsöffnung des Verdampfers definiert. Werden mindestens zwei Linearverdampferquellen verwendet, hat sich weiterhin als vorteilhaft erwiesen, wenn die Linearverdampferquellen einen Abstand von 0,01 m bis 3,00 m, bevorzugt 0,1 m bis 2 m, insbesondere 0,15 m bis 1 m, zueinander haben. Als Verdampferabstand wird hierbei die kürzeste geradlinige Entfernung der zu einander zeigenden Dampfaustrittsöffnungen der zwei Linearverdampferquellen definiert.

Weiterhin ist es von Vorteil, wenn sich in der Verdampferkammer mindestens eine punkt- und/oder linienförmige Ionenstrahlquelle oder andere Plasmaquelle befindet, die auch beheizt sein kann, deren lonenstrahl(en) oder deren Plasma mehr oder weniger in Interaktion mit dem von mindestens einer Linearverdampferquelle austretenden Molekularstrahl(en) des Verdampfungsguts, insbesondere Kupfer, Indium, Gallium, aber auch Gold, Aluminium, Silber Natrium, Kalium, und Lithium treten können. Interaktion heißt in diesem Zusammenhang, dass sich die lonenstrahlen oder die Plasmen und die Molekularstrahlen während der Beschichtung im Beschichtungsbereich auf dem Substrat zumindest teilweise überlappen.

In diesem Zusammenhang oder alternativ kann vorgesehen sein, dass diese punkt- und/oder linienförmige Ionenstrahlquelle oder Plasmaquelle nahe der äußeren Begrenzung der Verdampferkammer oder im Zentrum der Verdampferkammer positioniert ist. Dadurch wird bei beispielsweise eine Substratvorbehandlung oder eine gezielte Modifikation der MoSe-Übergangsschicht ermöglicht, während bei einer zentraler platzierten punkt- und/oder linienförmige Ionenstrahlquelle eine bessere Überlappung mit (Verdampfer)Molekularstrahlen erfolgen würde, was bei einer Anordnung nahe am Rand eingeschränkt würde.

Schließlich wird selbständiger Schutz beansprucht für das erfindungsgemäße Verfahren zur Beschichtung von Substraten, das sich dadurch auszeichnet, dass zumindest als eine Verdampferquelle eine erfindungsgemäße Linearverdampferquelle verwendet wird und bevorzugt die erfindungsgemäße Verdampferkammer eingesetzt wird. Vorteilhaft ist dann vorgesehen, dass die Prozessumgebung der Verdampferkammer bevorzugt Schwefel, Tellur und/oder Selen aufweist und insbesondere zumindest eine Chalkopyritschicht erzeugt wird.

Die Merkmale der vorliegenden Erfindung sowie ihre Vorteile werden nun anhand der Beschreibung bevorzugter Ausführungsbeispiele im Zusammenhang mit den Figuren deutlich gemacht. Dabei zeigen:
- Fig. 1: einen Linearverdampfer in einer ersten Ausgestaltung,
- Fig. 2: ein Drosselelement des Linearverdampfers nach Fig. 1,
- Fig. 3: eine Verdampferkammer mit zwei Linearverdampfern nach Fig. 1,
- Fig. 4: ein Ausführungsbeispiel der Verdampferkammer,
- Fig. 5: ein Beispiels einer abgeschiedenen Schichtfolge einer CIS-Dünnschichtsolarzelle,
- Fig. 6a: einen Linearverdampfer in einer zweiten Ausgestaltung,
- Fig. 6b: einen erfindungsgemäßen Linearverdampfer in einer bevorzugten Ausgestaltung und
- Fig. 7a und 7b: eine erfindungsgemäße Düsenplatte in einer bevorzugten Ausgestaltung in einer Draufsicht und einer Querschnittsansicht.

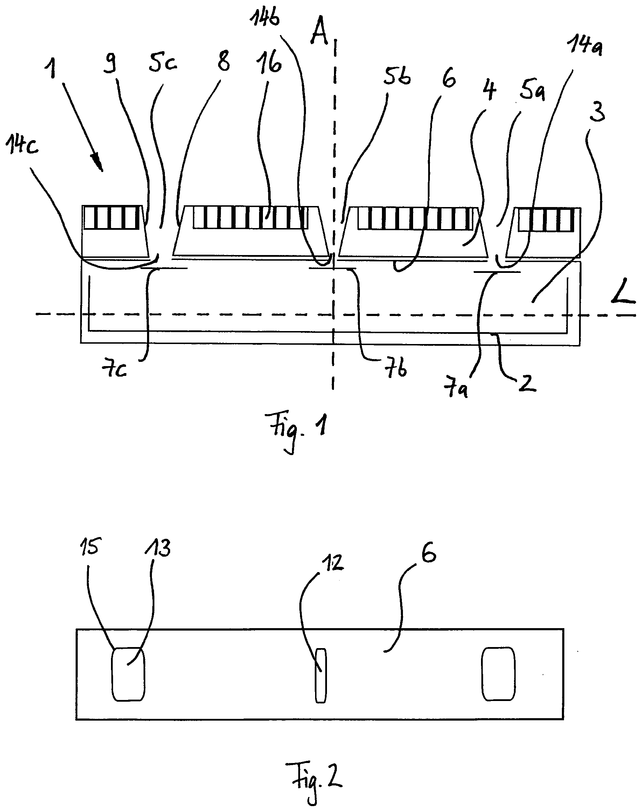

In Fig. 1 ist rein schematisch eine nicht erfindungsgemäße Linearverdampferquelle 1 in einer ersten Ausgestaltung im Schnitt abgebildet. Die Linearverdampferquelle 1 weist einen Verdampfungsmaterialbehälter 2 mit einer Vertiefung 3 zur Aufnahme von zu verdampfendem Material (nicht gezeigt) auf. Weiterhin ist eine Düsenplatte 4 mit Düsen mit Dampfaustrittsöffnungen 5a, 5b, 5c vorgesehen, die in Längsrichtung L der Linearverdampferquelle 1 beabstandet zueinander angeordnet sind. Außerdem ist ein Drosselelement 6 vorgesehen und Blendenelemente 7a, 7b, 7c.

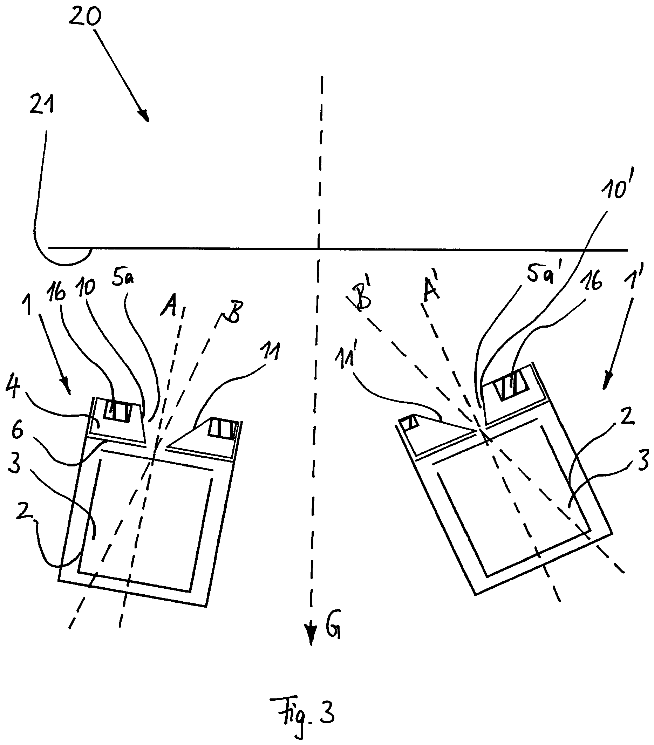

Die Dampfaustrittsöffnungen 5a, 5b, 5c weisen jeweils vier Wandbereiche 8, 9, 10, 11 auf, wobei zwei Wandbereiche 8, 9 sich senkrecht zur Längsrichtung L erstrecken und zwei Wandbereiche 10, 11 parallel zur Längsrichtung L, wie in Fig. 3 näher dargestellt ist. Die Dampfaustrittsöffnungen 5a, 5b, 5c weisen grundsätzlich eine sich konisch öffnende Gestalt auf, wobei die sich parallel zur Längsrichtung L erstreckenden Wandbereiche 10, 11 gegenüber dem Düsenelement 4 eine unterschiedliche Neigung aufweisen. Auch die sich senkrecht zur Längsrichtung L erstreckenden Wandbereiche 8, 9 der beiden äußeren Dampfaustrittsöffnungen 5a, 5c weisen gegenüber dem Düsenelement 4 eine unterschiedliche Neigung auf. Die mittlere Dampfaustrittsöffnung 5b weist dagegen sich senkrecht zur Längsrichtung L erstreckende Wandbereiche auf, die eine gleiche Neigung gegenüber dem Düsenelement 4 aufweisen. Gegenüber der Behälterachse A verlaufen somit die Längsachsen B der Dampfaustrittsöffnungen 5a, 5b, 5c verkippt.

Vorliegend ist pro Düse jeweils eine Dampfaustrittsöffnung 5a, 5b, 5c vorgesehen, so dass identische Elemente vorliegen. Allerdings kann auch vorgesehen sein, dass eine oder mehrere Düsen mehrere Dampfaustrittsöffnungen aufweisen.

Das Drosselelement 6 weist, wie in Fig. 2 gezeigt ist, jeweils den Dampfaustrittsöffnungen 5a, 5b, 5c zugeordnete Drosselöffnungen 12, 13 auf, deren Querschnittsflächen im Wesentlichen der Anfangsöffnung 14a, 14b, 14c der Dampfaustrittsöffnungen 5a, 5b, 5c entsprechen. Vorliegend ist zusätzlich vorgesehen, dass die Eckbereiche 15 der Drosselöffnungen 12, 13 abgerundet ausgebildet sind. Das Drosselelement 6 dient so also nicht der Regulation der Molekularstrahldichte sondern zum Schutz des Düsenelements 4 gegenüber dem Verdampfungsgut. Allerdings kann eine gezielte Querschnittsverkleinerung einzelner oder aller Drosselöffnungen 12, 13 gegenüber den Anfangsöffnungen 14a, 14b, 14c der Dampfaustrittsöffnungen 5a, 5b, 5c vorgesehen werden, um die einzelnen Molekularstrahldichten zu regulieren.

Die Drosselöffnungen 12, 13 sind in Sichtrichtung zwischen der Vertiefung 3 und der Dampfaustrittsöffnungen 5a, 5b, 5c angeordnet. Zwischen den Drosselöffnungen 12, 13 und der Vertiefung 3 wiederum sind die Blendenelemente 7a, 7b, 7c der jeweiligen Drosselöffnung 12, 13 und der jeweiligen Dampfaustrittsöffnungen 5a, 5b, 5c zugeordnet. Die Blendenelemente 7a, 7b, 7c weisen dabei jeweils eine solche Ausdehnung auf, dass sie in Sichtrichtung die Drosselöffnungen 12, 13 jeweils vollständig abdecken, so dass das Austreten von Verdampfungsmaterial als Spritzer durch die Dampfaustrittsöffnungen 5a, 5b, 5c wirksam unterbunden ist.

Das Düsenelement 4 ist an der Linearverdampferquelle 1 mittels einer clipsartigen Verbindung befestigt, so dass ein leichter Austausch erfolgen kann gegen ein anderes Düsenelement 4. Außerdem kann damit das Düsenelement 4 auch in einer um die Behälterachse A gedrehten Ausrichtung und in einer um die Längsrichtung L gedrehten Ausrichtung an der Linearverdampferquelle 1 angeordnet werden, so dass sich schon mit einem Düsenelement 4 verschiedene Strahlformungen verwirklichen lassen, selbst wenn die Düsengeometrien fixiert sind. Alternativ kann natürlich auch vorgesehen sein, dass einer oder mehrere der Wandbereiche 8, 9, 10, 11 gegenüber dem Düsenelement 4 verkippbar sind, um besondere Strahlformungen einzustellen.

Weiterhin sind Hitzereflektoren 16 in das Düsenelement 4 eingearbeitet. Diese Hitzereflektoren 16 verringern den Temperaturgradienten zwischen der Schmelzoberfläche des Verdampfungsguts und den Dampfaustrittsöffnungen 5a, 5b, 5c. Durch den Einsatz dieser Hitzereflektoren 16 wird die Ablagerung und somit das Zuwachsen der Dampfaustrittsöffnungen 5a, 5b, 5c sowohl mit Verdampfungsgut als auch mit dessen Verbindungen beispielsweise von in der Verdampferkammer befindlichem Selen verhindert.

In Fig. 3 ist eine nicht erfindungsgemäße Verdampferkammer 20 in einer Ausführungsform rein schematisch im Schnitt dargestellt. In der Verdampferkammer 20 wird ein flexibles Bandsubstrat 21 mittels einer ebenen Substratführung (nicht gezeigt), beispielsweise mittels Transportrollen und Bandtrommeln durch einen Beschichtungsbereich 22 der Verdampferkammer 20 geführt, deren Außenwände ebenfalls nicht näher dargestellt sind.

Die Verdampferkammer 20 weist zwei Linearverdampferquellen 1, 1' auf, wobei dieselben und gleiche Elemente mit den selben bzw. gleichen Bezugszeichen versehen sind. Die Linearverdampferquellen 1, 1' weisen jeweils unterschiedlich zur Gravitationsrichtung G ausgerichtete Behälterachsen A, A' auf, wobei die Verkippung der Behälterachsen A, A' gegenüber der Gravitationsrichtung G über geeignete Mittel (nicht gezeigt) angepasst werden kann. Außerdem sind die Längsachsen B, B' der Dampfaustrittsöffnungen 5a, 5a' der Linearverdampferquellen 1, 1' unterschiedlich gegenüber den jeweiligen Behälterachsen A, A' verkippt. Dadurch wird erreicht, dass die Dampfstrahlen der Linearverdampferquellen 1, 1' jeweils besonders geformt sind und sich auf dem Substrat optimal abscheiden sowie vermengen. Beispielsweise wird in der ersten Linearverdampferquelle 1 Indium verdampft und in der zweiten Linearverdampferquellen 1' Selen und es ist eine dritte Beschichtungseinrichtung für Kupfer vorgesehen, um auf dem Substrat eine Chalkopyritschicht für eine Dünnschichtsolarzelle abzuscheiden. Bei diesem speziellen Verfahren können die Linearverdampferquellen 1, 1' besonders eng, d.h. bis zu 0,05 m, beabstandet sein, und um eine besonders homogene Schicht abzuscheiden, sollten die Linearverdampferquellen 1, 1' auch so nah wie möglich, d.h. beispielsweise 0,1 m vom Substrat entfernt angeordnet sein.

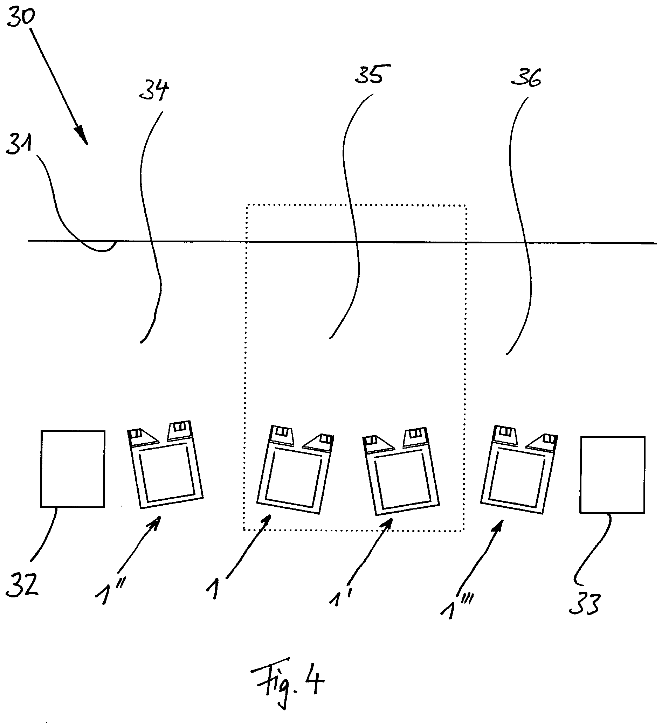

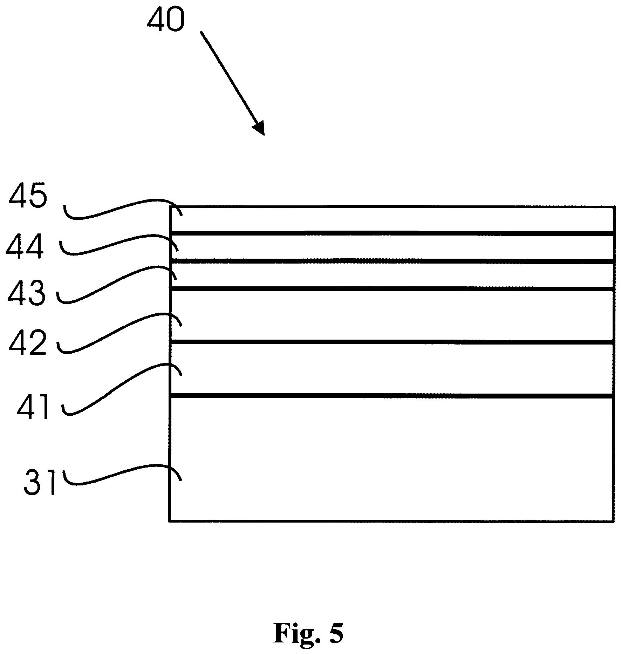

In Fig. 4 ist ein Ausführungsbeispiel einer nicht erfindungsgemäßen Verdampferkammer 30 rein schematisch dargestellt, deren übliche Komponenten wie Pumpen, Schleusen, Ventile und dgl. dem Fachmann geläufig sind und daher nicht gesondert gezeigt werden. In diesem Fall wird in einer Beschichtungsanlage 30 eine CIS-Schicht aus Cu(Ga, In)Se₂ auf Glassubstrat 31 im Durchlaufverfahren (engl. in line) abgeschieden, um eine CIS-Dünnschichtsolarzelle 40 entsprechend Fig. 5 herzustellen. Dabei hat es sich als besonders vorteilhaft erwiesen, wenn das schon mit einem Rückkontakt 41 beschichtete Substrat 31 zunächst mit Kupfer, welches aus einer in Fig.1 dargestellten Linearverdampferquelle 1" verdampft wird, und einem aus Selen bestehenden Ionenstrahl aus der ersten Ionenstrahlquelle 32 beschichtet wird, um eine Selen-Kupfer-Mischschicht 42 zu bilden, wobei sich auf der Beschichtungsfläche der Molekularstrahl der Linearverdampferquelle 1" und der Ionenstrahl der Ionenstrahlquelle 32 überlappen. Anschließend wird das so beschichtete Substrat 31 mit Gallium und Indium mit jeweils einer in Fig. 1 abgebildeten Linearverdampferquelle 1, 1' beschichtet, um eine Gallium-Indium-Mischschicht 43 zu bilden. Um den Wirkungsgrad der Solarzelle, welcher im Wesentlichen durch die Absorber bestimmt wird, zu erhöhen, wird Kaliumfluorid aus einem der in Fig.1 beschriebenen Linearverdampferquelle 1''', deren Molekularstrahl sich mit einem weiteren schwefelhaltigen Ionenstrahl einer zweiten Ionenstrahlquelle 33 überlappt, beschichtet, um eine Kalium-Selen-Mischschicht 44 zu bilden.

Diese Abscheideprozesse werden jeweils in unterschiedlichen und von einander getrennten Bereichen 34, 35, 36 der Beschichtungsanlage 30 durchgeführt. Um die ionenstrahlgestützten Teilprozesse durchzuführen, hat sich ein möglichst großer Abstand von bis zu 3,0 m der Linearverdampferquellen 1, 1', 1", 1" zum Substrat 31 als vorteilhaft herausgestellt. Daraus resultierend ist ein möglichst großer Abstand des Kupferlinearverdampfers zu den Gallium- und Indiumlinearverdampfer von bis zu 1,00 m einzustellen. Eine Vermischung von Kupfer, Indium und Gallium in diesem Bereich des beschriebenen Mehrschrittbeschichtungsprozess würde sich negativ auf den Wirkungsgrad der Solarzelle auswirken. Da die Linearverdampferquellen 1, 1', 1", 1''' in diesem speziellen Anwendungsfall einen großen Abstand zum aufgeheizten Substrat 31 haben, müssen die Düsen mit Hitzereflektoren 16, bestehend aus Tantal versehen sein, da sich sonst Selenhaltige Verbindungen an den Dampfaustrittsöffnungen 5a, 5b, 5c ablagern und diese sonst zuwachsen würden.

Zur Bildung der Dünnschichtsolarzelle 40 wird außerdem noch einer CdS-Schicht 44 als Pufferschicht und einer Frontelektrode 45 auf die aus den Schichten 42 und 43 gebildete Cu(Ga, In)Se₂-Absorber-Schicht aufgebracht.

Fig. 4 zeigt dabei ein Anwendungsbeispiel zur CIS-Abscheidung. Soll dieser schematisch dargestellte Prozess auf größere Substratbreiten aufskaliert werden, müssen auch die Linearverdampferquellen und Linearionenstrahlquellen entsprechend skaliert werden. Ein Verdampfungsmaterialbehälter von z.B. 1 m lässt sich evtl. noch bei der Reinigung und Verdampfungsmaterialbefüllung, wozu der Verdampfungsmaterialbehälter aus der Linearverdampferquelle entnommen werden muss, handhaben. Bei einer noch längeren Linearverdampferquelle mit einer Verdampfungsmaterialbehälterlänge von beispielsweise 3 m, 5 m oder später gar bis zu 10 m ist das nicht mehr möglich. Allein die Entnahme des Verdampfungsmaterialbehälters gestaltet sich sehr schwierig und ist wahrscheinlich nicht machbar. Der Verdampfungsmaterialbehälter kann bei ungünstiger Handhabung alleine durch sein Eigengewicht zerbrechen. Wird der Verdampfungsmaterialbehälter (2) mit Verdampfungsmaterial aufgefüllt, erhöht sich das Risiko, dass der Verdampfungsmaterialbehälter brechen könnte. Weiterhin wird für die Wartung und Lagerung, beispielsweise von Ersatzverdampfungsmaterialbehältern, zusätzlich Platz beansprucht.

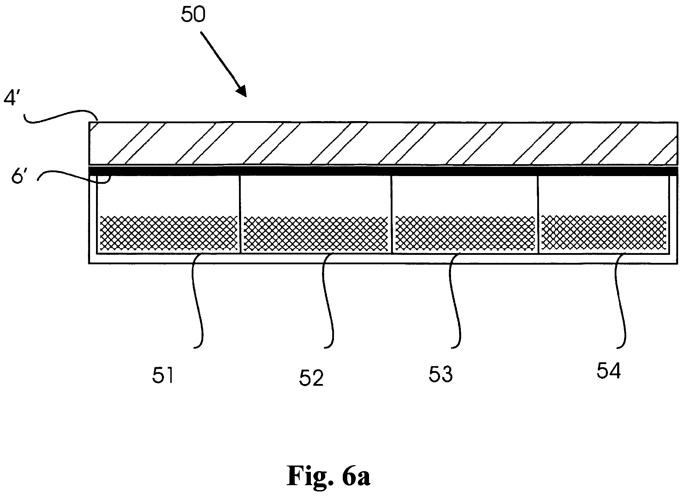

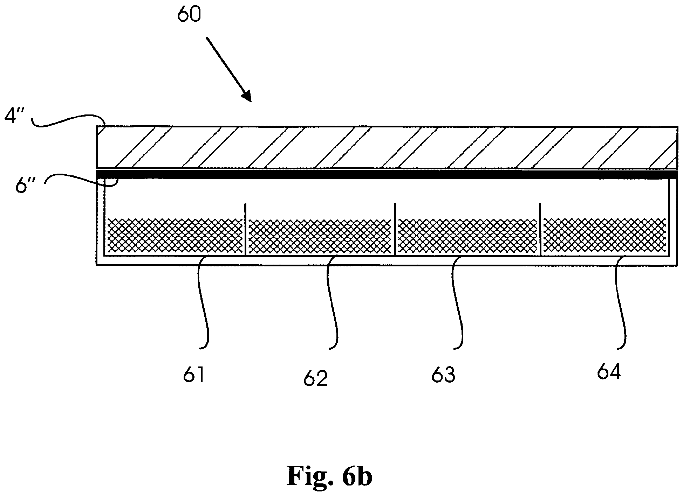

Daher ist der Verdampfungsmaterialbehälter, insbesondere bei für die Massenproduktion von CIS tauglichen Linearverdampferquellen, in mehrere kleinere, sogenannte Verdampfungsmaterialbehälter-Module aufgeteilt. Fig. 6a und 6b zeigen zwei Ausführungsbeispiele von Linearverdampferquellen 50, 60, bei denen die Module 51, 52, 53, 54, 61, 62, 63, 64 unterschiedlich ausgebildet sind.

Der Vorteil des in Fig. 6a dargestellten Konzepts, bei dem sich in jedem Modul 51, 52, 53, 54 ein separates Dampfdruckgleichgewicht dadurch einstellt, dass diese von einander separiert sind, ist ein gleichmäßiger Verdampfungsmaterialverbrauch.

Nachteilig hingegen ist eine komplexe Ausgestaltung der darüber liegenden Komponenten, nämlich der Drosselelement(e) 6' und der Düsenelement(e) 4'.

Der Vorteil des in Fig. 6b dargestellten erfindungsgemäßen Konzepts der Verdampfungsmaterialbehälter-Module, bei dem sich in/über jedem Modul 61, 62, 63, 64 der gleiche Dampfgleichgewichtsdruck dadurch einstellt, dass diese nicht von einander separiert sind, ist eine stabile Querhomogenität des Substrates bei relativ einfacher Ausgestaltung der darüber liegenden Komponenten, nämlich der Drosselelement(e) 6" und der Düsenelement(e) 4".

Durch die in Fig. 2 dargestellte größere Querschnittsfläche 14a, 14c der äußeren Dampfaustrittsöffnungen 5a, 5c gegenüber der inneren Dampfaustrittsöffnung 5b, wird bewirkt, dass auch in den Randbereichen eines Substrates genügend Material aufgebracht wird. Die in Fig. 1 dargestellte Verkippung der Düsenachse B gegenüber der Behälterachse A in Bezug auf die Längsrichtung L führt zu einer besonders hohen Homogenität des Verdampfungsmaterials entlang der Längsrichtung L, also entlang einer Querrichtung eines senkrecht zur Längsrichtung L der Linearverdampferquelle 1 vorbei geführten Substrates 21.

Diese erfindungsgemäße Ausgestaltung bewirkt somit eine besonders hohe Homogenität und ermöglicht hohe Masseflussraten. Die Stabilität der Masseflussraten kann noch dadurch erhöht werden, dass die Behälterachsen A, A' der Linearverdampferquellen 1, 1' parallel zur Gravitationsrichtung G ausgerichtet werden. Dann befindet sich in der Vertiefung 3 jeweils Verdampfungsmaterial mit konstanter Oberfläche, so dass ein konstanter Massefluss auch bis vollständigen Verbrauch des Verdampfungsmaterials sicher gestellt ist. Für diesen Fall wären dann die Linearverdampferquellen 1, 1' näher zueinander zu positionieren und/oder die Düsenachsen B, B' stärker gegenüber den Behälterachsen A, A' zu verkippen, damit der Dampfstrom möglichst senkrecht auf die Substratoberfläche trifft. Allerdings kann ein nicht senkrechtes Auftreffen in bestimmten Fällen sinnvoll und gewünscht sein.

Auch wenn beim bevorzugten Ausführungsbeispiel mehrere Düsen mit jeweils einer Dampfaustrittsöffnung 5a, 5b, 5c gezeigt sind, kann erfindungsgemäß auch vorgesehen sein, dass die Linearverdampferquelle eine einzige Düse mit einer einzigen Dampfaustrittsöffnung aufweist, die sich dann in Längsrichtung der Linearverdampferquelle erstreckt.

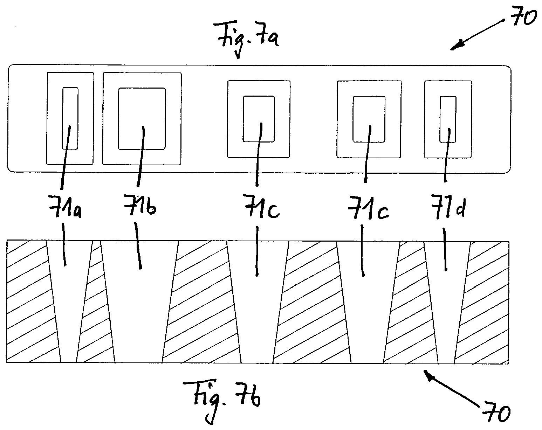

Eine bevorzugte Ausgestaltung der erfindungsgemäßen Düsenplatte 70 wird rein schematisch in Fig. 7a und 7b in einer Draufsicht von oben bzw. einer Querschnittsansicht gezeigt.

Es ist zu erkennen, dass die erfindungsgemäße Düsenplatte 70 unterschiedliche Düsen 71a, 71b, 71c, 71d aufweist, nämlich unterschiedlich hinsichtlich der Beabstandung zueinander und der jeweiligen Breiten sowohl in Längs- als auch Querrichtung der Düsenplatte. Die Öffnungswinkel der Düsen 71a, 71b, 71c, 71d sind zwar im Beispiel dieselben, jedoch können auch hier Variationen vorgenommen werden, um bestimmte gewünschte Strahlprofile einzustellen.

Der Einsatz des erfindungsgemäßen modular konstruierten Verdampfungsmaterialbehälters, der aus mehreren kleinen Verdampfungsmaterialbehältern 51, 52, 53, 54, 61, 62, 63, 64 zusammengesetzt ist, ermöglicht eine einfache Aufskalierung bzgl. der Längserstreckung des Verdampfers 50, 60 und insbesondere bei sehr lang ausgeprägten Linearverdampferquellen 50, 60 ein einfaches Handling. Außerdem wird bei Wartungsarbeiten das Risiko einer fahrlässigen Zerstörung des Verdampfungsmaterialbehälters deutlich minimiert. Zudem können einzelne, kleinere nicht mehr funktionsfähige Verdampfungsmaterialbehälter 51, 52, 53, 54, 61, 62, 63, 64 schnell ausgetauscht werden, was zudem kostengünstiger ist, als einen großen Verdampfungsmaterialbehälter zu ersetzen.

Zusätzlich kann auch vorgesehen sein, dass die Düsenplatte modular aus mehreren Düsenplattensegmenten ausgebildet ist (nicht gezeigt).

Die nicht erfindungsgemäße Linearverdampferquelle 1, 1' hat gegenüber punktförmigen Verdampferzellen eine 30% bis 40% bessere Materialausbeute. Gegenüber bisher bekannten Linearverdampferquellen ist die Homogenität deutlich verbessert und sie ist vor allem bei flexibler Substratführung und wachsender Substratbreite wesentlich besser geeignet und vor allem sehr flexibel anpassbar an bestimmte Bedürfnisse.

Diese Anpassbarkeit besteht vor allem aufgrund der erfindungsgemäß vorgesehenen besonderen Düsenform bzw. deren Ausrichtung zur Behälterachse A, A', die in unterschiedlicher Art und Weise über verschiedenen Düsenelemente 4 bereitgestellt werden kann.

Darüber hinaus kann aber auch eine Verstellbarkeit der Düsenform selbst innerhalb eines besonders dazu angepassten Düsenelements vorgesehen sein, bei dem beispielsweise die Wandbereiche 8, 9, 10, 11 verkippbar angeordnet sind.

## Patentansprüche

1. Linearverdampferquelle (1, 1', 1", 1'''; 50; 60), insbesondere für Vakuumbeschichtungsanlagen, mit zumindest einem Verdampfungsmaterialbehälter (2) mit einer Vertiefung (3) zur Aufnahme des Verdampfungsmaterials, zumindest einer Heizquelle und mit zumindest zwei in Längsrichtung (L) der Linearverdampferquelle (1, 1', 1", 1'''; 50; 60) beabstandet angeordneten Düsen, wobei die Düsen jeweils mindestens eine Dampfaustrittsöffnung (5a, 5b, 5c) aufweisen, wobei der Verdampfungsmaterialbehälter (2) eine Behältersachse (A, A') aufweist,
**dadurch gekennzeichnet, dass**
die zumindest eine Dampfaustrittsöffnung (5a, 5b, 5c) zumindest zwei Wandabschnitte (8, 9 10, 11), die sich bevorzugt im Wesentlichen senkrecht zur Längserstreckung (L) erstrecken, aufweist, die nicht parallel zueinander orientiert und/oder orientierbar sind, wobei der Verdampfungsmaterialbehälter (2) in mindestens zwei Verdampfungsmaterialbehälter-Module (51, 52, 53, 54; 61, 62, 63, 64) aufteilbar ist, die im zusammengefügten Zustand des Verdampfungsmaterialbehälter (2) nicht voneinander separiert sind, so dass sich durch Verdampfung von Verdampfungsmaterial in dem jeweiligen Verdampfungsmaterialbehälter-Modul (51, 52, 53, 54; 61, 62, 63, 64) in/über jedem Verdampfungsmaterialbehälter-Modul (51, 52, 53, 54; 61, 62, 63, 64) der gleiche Dampfgleichgewichtsdruck einstellt.

2. Linearverdampferquelle (1, 1', 1", 1''') nach Anspruch 1, **dadurch gekennzeichnet, dass** die Dampfaustrittsöffnung (5a, 5b, 5c) in Bezug auf die beiden Wandabschnitte (8, 9, 10, 11) konisch, insbesondere asymmetrisch konisch erweitert ausgebildet ist.

3. Linearverdampferquelle (1, 1', 1", 1"') nach Anspruch 1 oder 2, **dadurch gekennzeichnet, dass** der Verdampfungsmaterialbehälter modular mit 3 bis 40, bevorzugt 3 bis 20, insbesondere 5 bis 10, kleineren Verdampfungsmaterialbehälter-Modulen (51, 52, 53, 54; 61, 62, 63, 64) aufgebaut ist.

4. Linearverdampferquelle (1, 1', 1", 1''') nach einem der Ansprüche 1 bis 3, **dadurch gekennzeichnet, dass** die Düse mindestens einen Hitzereflektor (16) aufweist, der bevorzugt aus mindestens einem Blech eines temperaturbeständigen Materials aus der Gruppe der Metalle der vierten bis zehnten Nebengruppe des Periodensystems der Elemente und/oder deren Legierungen, vorzugsweise Wolfram, Titan, Molybdän und Tantal, besteht.

5. Linearverdampferquelle (50; 60) nach Anspruch 4, **dadurch gekennzeichnet, dass** der Hitzereflektor (16) neben oder um die Dampfaustrittsöffnung (5a, 5b, 5c) herum angeordnet ist

6. Linearverdampferquelle (50; 60) nach einem der Ansprüche 1 bis 5, **dadurch gekennzeichnet, dass** die Längserstreckung L_{Längs} der Verdampfungsmaterialbehälter-Module (51, 52, 53, 54; 61, 62, 63, 64) wesentlich größer als deren Quererstreckung L_{Quer} ist, wobei das Verhältnis von Längs- zur Quererstreckung L_{Längs}/ L_{Quer} der Verdampfungsmaterialbehälter- Module (51, 52, 53, 54; 61, 62, 63, 64) bevorzugt mindestens 5 und maximal 30, vorzugsweise 15 ≤ L_{Längs}/L_{Quer} ≤ 25, insbesondere 19 ≤ L_{Längs}// L_{Quer} ≤ 22 beträgt.

7. Linearverdampferquelle nach einem der Ansprüche 1 bis 6, **dadurch gekennzeichnet, dass** die Dampfaustrittsöffnung (5a, 5b, 5c) eine Längsachse aufweist, die zur Behälterachse verkippt angeordnet und/oder anordenbar ist, wobei die Verkippung vorteilhaft 1° bis 90°, bevorzugt 10° bis 60°, besonders bevorzugt 10° bis 45°, insbesondere 20° bis 30° beträgt.

8. Linearverdampferquelle nach einem der Ansprüche 1 bis 7, **dadurch gekennzeichnet, dass** die Düsen in zumindest einem Düsenelement (4), bevorzugt einer Düsenplatte, angeordnet sind, das insbesondere lösbar mit dem Verdampfungsmaterialbehälter (2) verbunden ist, wobei die Düsenplatte bevorzugt massiv, insbesondere aus Graphit bestehend ausgebildet ist.

9. Linearverdampferquelle nach Anspruch 8, **dadurch gekennzeichnet, dass** das Düsenelement (4) in einer um die Behälterachse (A) und/oder in einer um die Längsrichtung (L) gedrehten Ausrichtung mit dem Verdampfungsmaterialbehälter (2) verbindbar ist, so dass sich mit dem Düsenelement (4) verschiedene Strahlformungen verwirklichen lassen, selbst wenn die Düsengeometrien in dem Düsenelement (4) fixiert sind.

10. Linearverdampferquelle nach einem der vorherigen Ansprüche, **dadurch gekennzeichnet, dass** zwischen Düse und Vertiefung (3) ein Drosselelement (6) angeordnet ist, das zumindest eine Drosselöffnung (12, 13) aufweist, die in Sichtrichtung zwischen Düse und Vertiefung (3) angeordnet ist, wobei bevorzugt die Gesamtquerschnittsfläche der Drosselöffnungen (12, 13) der jeweiligen Düse bei in Bezug auf die Längserstreckung (L) zumindest einer weiter außen gelegenen Düse gleich oder größer ist als bei zumindest einer weiter innen liegenden Düse, wobei bevorzugt vorgesehen ist, **dass** in Sichtrichtung zwischen Vertiefung (3) und Drosselöffnung (12, 13) und/oder zwischen Drosselöffnung (12, 13) und Düse ein Blendenelement (7a, 7b, 7c) als Spritzschutz angeordnet ist, das insbesondere die Gesamtquerschnittsfläche der Drosselöffnungen (12, 13) in Sichtrichtung verdeckt.

11. Verfahren zur Beschichtung von Substraten (21), **dadurch gekennzeichnet, dass** zumindest eine Linearverdampferquelle (1, 1') nach einem der Ansprüche 1 bis 10 verwendet wird, wobei die Prozessumgebung bevorzugt Schwefel, Tellur und/oder Selen aufweist und insbesondere zumindest eine Chalkopyritschicht erzeugt wird.

## Claims

1. Linear evaporation source (1, 1', 1", 1"'; 50; 60), in particular for vacuum deposition arrangements, comprising:
at least one evaporation material container (2) including an indentation (3) for receiving the evaporation material,
at least one heat source,
and at least two nozzles arranged offset in longitudinal direction (L) of the linear evaporation source (1, 1', 1", 1"'; 50; 60),
wherein the nozzles respectively include at least one vapor outlet opening (5a, 5b, 5c),
wherein the evaporation material container (2) includes a container axis (A, A'),
**characterized in that** the at least one vapor outlet opening (5a, 5b, 5c) includes at least two wall sections (8, 9, 10, 11) which preferably extend substantially vertical to the longitudinal direction (L) and which are oriented not parallel and/or orientable not parallel to one another, wherein the evaporation material container (2) is separable into at least two evaporation material container modules (51, 52, 53, 54; 61, 62, 63, 64) which are not separated from one another in a joined condition of the evaporation material container (2) so that an identical vapor equilibrium pressure is established in/over each evaporation material container module (51, 52, 53, 54; 61, 62, 63, 64) through evaporating evaporation material in the respective evaporation material container module (51, 52, 53, 54; 61, 62, 63, 64).

2. Linear evaporation source (1, 1', 1", 1''') according to claim 1, **characterized in that** the vapor outlet opening (5a, 5b, 5c) is configured conical with respect to the two wall sections (8, 9, 10, 11), in particular configured asymmetrically conically expanded.

3. Linear evaporation source (1, 1', 1", 1''') according to claim 1 or 2, **characterized in that** the evaporation material container is configured modular with 3 to 40, preferably 3 to 20, in particular 5 to 10 smaller evaporation material container modules (51, 52, 53, 54; 61, 62, 63, 64).

4. Linear evaporation source (1, 1', 1", 1"') according to one of the claims 1 through 3, **characterized in that** the nozzle includes at least one heat reflector (16), which is preferably made from at least one piece of sheet metal made from a temperature resistant material from the group of metals from the fourth to ninth subgroup of the period system of elements and/or their alloys, preferably tungsten, titanium, molybdenum and tantalum.

5. Linear evaporation source (50; 60) according to claim 4, **characterized in that** the heat reflector (16) is arranged adjacent to or about the vapor outlet opening (5a, 5b, 5c).

6. Linear evaporation source (50; 60) according to one of the claims 1 through 5, **characterized in that** the longitudinal extension (L_{Long}) of the evaporation container modules (51, 52, 53, 54; 61, 62, 63, 64) is much greater than their transversal extension (L_{Trans}), wherein the ratio of longitudinal extension to transversal extension L_{Long}/ L_{Trans} of the evaporation material container modules (51, 52, 53, 54; 61, 62, 63, 64) is preferably at least 5 and at the most 30, more preferably 15 ≤ L_{Long}/ L_{Trans} ≤ 25, in particular 19 ≤ L_{Long}/ L_{Trans} ≤ 22.

7. Linear evaporation source (50; 60) according to one of the claims 1 through 6, **characterized in that** the vapor outlet opening (5a, 5b, 5c) has a longitudinal axis which is arranged and/or arrangeable tilted relative to the container axis, wherein the tilt is advantageously 1° to 90°, preferably 10° to 60°, particularly preferably 10° to 45°, in particular 20° to 30°.

8. Linear evaporation source according to one of the claims 1 through 7, **characterized in that** the nozzles are arranged in at least one nozzle element (4), preferably a nozzle plate which is in particular disengageably connected with the evaporation material container (2), wherein the nozzle plate is preferably configured solid, in particular made from graphite.

9. Linear evaporation source according to claim 8, **characterized in that** the nozzle element (4) is connectable with the evaporation material container in an orientation that is rotatable about the container axis (A) and/or about the longitudinal direction (L), so that various beam shapes can be implemented with the nozzle element (4) even when the nozzle geometries in the nozzle element (4) are fixated.

10. Linear evaporation source according to one of the preceding claims, **characterized in that** a throttle element (6) is arranged between the nozzle and the indentation (3), wherein the throttle element includes at least one throttle opening (12, 13) which is arranged in viewing direction between the nozzle and the indentation (3), wherein preferably an overall cross-sectional area of the throttle openings (12, 13) of the respective nozzle for at least one nozzle which is arranged further outside with respect to the longitudinal direction (L) is equal to or greater than for at least one nozzle that is arranged further inside, wherein it is preferably provided that an aperture element is arranged in viewing direction between the indentation (3) and the throttle opening (12, 13) and/or between the throttle opening (12, 13) and the nozzle as a splash guard, wherein the aperture element covers in particular the overall cross-sectional area of the throttle openings (12, 13) in viewing direction.

11. Method for coating substrates (21), **characterized in that** at least one linear evaporation source (1, 1') according to one of the claims 1 through 10 is used, wherein the process environment preferably includes sulfur, telluride, and/or selenium, and in particular at least one chalcopyrite layer is generated.

## Revendications

1. Source de vaporisation linéaire (1, 1', 1", 1''' ; 50 ; 60), en particulier pour des installations de revêtement sous vide, avec tout au moins un conteneur de matière de vaporisation (2), lequel comprend un renfoncement (3) en vue de la réception de la matière de vaporisation, avec tout au moins une source de chaleur et avec tout au moins deux buses, lesquelles sont disposées de manière espacée dans la direction longitudinale (L) de la source de vaporisation linéaire (1, 1', 1", 1''' ; 50 ; 60) ;
selon laquelle les buses présentent respectivement au moins un orifice de sortie de la vapeur (5a, 5b, 5c) ;
selon laquelle le conteneur de matière de vaporisation (2) présente un axe de conteneur (A, A') ;
**caractérisée en ce que**
le tout au moins un orifice de sortie de la vapeur (5a, 5b, 5c) présente tout au moins deux sections de paroi (8, 9, 10, 11), lesquelles, de manière préférée, s'étendent pour l'essentiel à la perpendiculaire de l'extension longitudinale (L), et lesquelles ne sont pas orientées parallèlement l'une vis-à-vis de l'autre et/ou ne peuvent pas être orientées parallèlement l'une vis-à-vis de l'autre ;
selon laquelle le conteneur de matière de vaporisation (2) peut être divisé en au moins deux modules de conteneur de matière de vaporisation (51, 52, 53, 54 ; 61, 62, 63, 64), lesquels ne sont pas séparés l'un de l'autre quand le conteneur de matière de vaporisation (2) se trouve à l'état assemblé, de telle sorte que la même pression d'équilibre de la vapeur se met en place par la vaporisation de la matière de vaporisation dans le module respectif du conteneur de matière de vaporisation (51, 52, 53, 54 ; 61, 62, 63, 64), et ce dans ou à travers chaque module du conteneur de matière de vaporisation (51, 52, 53, 54 ; 61, 62, 63, 64) .

2. Source de vaporisation linéaire (1, 1', 1", 1''') selon la revendication 1, **caractérisée en ce que** l'orifice de sortie de la vapeur (5a, 5b, 5c) est conçu de manière conique au regard des deux sections de paroi (8, 9, 10, 11), et en particulier conçu en s'élargissant de manière conique et de manière asymétrique.

3. Source de vaporisation linéaire (1, 1', 1", 1''') selon la revendication 1 ou 2, **caractérisée en ce que** le conteneur de matière de vaporisation (2) est structuré de manière modulaire avec entre 3 et 40, de manière préférée entre 3 et 20, en particulier entre 5 et 10 modules plus petits de conteneur de matière de vaporisation (51, 52, 53, 54 ; 61, 62, 63, 64).

4. Source de vaporisation linéaire (1, 1', 1", 1''') selon l'une des revendications 1 à 3, **caractérisée en ce que** la buse présente au moins un réflecteur de chaleur (16), lequel est, de manière préférée, constitué d'au moins une tôle en un matériau résistant aux températures, issu du groupe constitué par les métaux allant du quatrième au dixième sous-groupe du tableau périodique des éléments et/ou issus de leurs alliages, de préférence le tungstène, le titane, le molybdène et le tantale.

5. Source de vaporisation linéaire (50 ; 60) selon la revendication 4, **caractérisée en ce que** le réflecteur de chaleur (16) est disposé à côté ou autour de l'orifice de sortie de la vapeur (5a, 5b, 5c).

6. Source de vaporisation linéaire (50 ; 60) selon l'une des revendications 1 à 5, **caractérisée en ce que** l'extension longitudinale L_{Längs} des modules du conteneur de matière de vaporisation (51, 52, 53, 54 ; 61, 62, 63, 64) est sensiblement plus grande que leur extension transversale L_{Quer} ;
selon laquelle le rapport L_{Längs} / L_{Quer} entre l'extension longitudinale et l'extension transversale des modules du conteneur de matière de vaporisation (51, 52, 53, 54 ; 61, 62, 63, 64) est compris, de manière préférée, entre au moins 5 et au plus 30, s'élève de préférence à 15 ≤ L_{Längs} / L_{Quer} ≤ 25, s'élève en particulier à 19 ≤ L_{Längs} / L_{Quer} ≤ 22.

7. Source de vaporisation linéaire selon l'une des revendications 1 à 6, **caractérisée en ce que** l'orifice de sortie de la vapeur (5a, 5b, 5c) présente un axe longitudinal, lequel est disposé et/ou peut être disposé de manière basculée par rapport à l'axe du conteneur ;
selon laquelle le basculement est compris, de manière avantageuse, entre 1° et 90°, de manière préférée entre 10° et 60°, de manière particulièrement préférée entre 10° et 45°, en particulier est compris entre 20° et 30°.

8. Source de vaporisation linéaire selon l'une des revendications 1 à 7, **caractérisée en ce que** les buses sont disposées dans tout au moins un élément de buse (4), de manière préférée dans une plaque de buse, lequel élément de buse (4) est, en particulier, relié de manière amovible avec le conteneur de matière de vaporisation (2) ;
selon laquelle la plaque de buse est conçue, de manière préférée, de manière massive, en particulier est constituée de graphite.

9. Source de vaporisation linéaire selon la revendication 8, **caractérisée en ce que** l'élément de buse (4) peut être relié avec le conteneur de matière de vaporisation (2) dans une orientation qui est mise en rotation autour de l'axe du conteneur (A) et/ou dans une orientation qui est mise en rotation autour de la direction longitudinale (L), de telle sorte que différentes formations de faisceau peuvent être réalisées au moyen de l'élément de buse (4), et ce même si les géométries des buses sont fixées dans l'élément de buse (4).

10. Source de vaporisation linéaire selon l'une des revendications précédentes, **caractérisée en ce qu'**un élément de restriction (6) est disposé entre la buse et le renfoncement (3), lequel élément de restriction (6) présente tout au moins une ouverture de restriction (12, 13) qui, dans le sens de la vision, est disposée entre la buse et le renfoncement (3) ;
selon laquelle, de manière préférée, toute la surface de la section transversale des ouvertures de restriction (12, 13) de la buse respective est, pour tout au moins une buse positionnée davantage à l'extérieur, au regard de l'extension longitudinale (L), égale ou plus grande que pour tout au moins une buse positionnée davantage à l'intérieur ;
selon laquelle il est prévu, de manière préférée, qu'un élément de diaphragme (7a, 7b, 7c) soit disposé, dans le sens de la vision, entre le renfoncement (3) et l'ouverture de restriction (12, 13) et/ou entre l'ouverture de restriction (12, 13) et la buse, en vue de servir de protection contre les projections, lequel élément de diaphragme (7a, 7b, 7c) recouvre en particulier toute la surface de la section transversale des ouvertures de restriction (12, 13) dans le sens de la vision.

11. Procédé destiné au revêtement de substrats (21), **caractérisé en ce que** tout au moins une source de vaporisation linéaire (1, 1') selon l'une des revendications 1 à 10 est utilisée ;
selon lequel l'environnement de mise oeuvre du procédé présente, de manière préférée, du soufre, du tellure et/ou du sélénium ; et
selon lequel, en particulier, tout au moins une couche de chalcopyrite est générée.
